# EUROPEAN PATENT APPLICATION

(11) **EP 2 722 679 A1**
(43) Date of publication of application: **23.04.2014**
(21) Application number: 12007204.6
(22) Date of filing: 18.10.2012
(51) Int. Cl.: G01R 15/18, H01F 27/06

(54) **Fastening means for current and/or voltage sensor**

(71) Applicant: ABB Technology AG, 8050 Zürich (CH)
(72) Inventor: Velesik, Petr, 60200 Brno (CZ); Podzemny, Jaromir, 62100 Brno (CZ); Raschka, David, 66491 Ivancice (CZ)
(74) Representative: Schmidt, Karl Michael

(57) **Abstract**

The invention relates to fastening means or device for fastening a voltage and/or current sensor on a electrical conductor, according to the preamble of claim 1. In order to enhance fasting means or device for fasting voltage sensors in such a way, that the fixation is accurate and reproductive as well, the invention is, that the fastening device comprise of a number of at least two fastening elements (3), each with a dowel pin clip, or a clamp at a first section (3') of the fastening element, and a support element at a second section (3") of the fastening element, so that the dowel pin clip (10) or the clamp has to be inserted into, or clamped on the housing of the sensor (2) at the first section (3'), and the support element at the second section (3") has to be fixed on the electrical conductor (1).

## Description

The invention relates to fasting means for current and/or voltage sensor in low- medium and high voltage use according to the preamble of claim 1.

A required position of a ring-core type low-, medium- or high- current and/or voltage sensing device is achieved by the sensing device design and its dimensions and by construction of an electrical device containing a source, i. e. a sensing device primary conductor, of a current and/or voltage signal to be measured. For fastening of the sensing device to the electrical device containing the primary conductor there is used either tightening strap or another supplementary fastening material such the bolts, an adhesive, etc. It introduces necessity of the additional fastening material and special assembling tools application what negatively influences the manufacturing time and production costs. Next disadvantage of the solution described above, especially in using tightening straps, is impossibility of the requested perpendicularity to the primary conductor and centering of the sensing device around the primary conductor ensurance what can lead to decreased measurement device sensing accuracy.

So it is an object of the invention to enhance fasting means or device for fasting current and/or voltage sensors in such a way, that the fixation is accurate and reproductive as well.

So based on this, the invention is, that the fastening device comprise a number of at least two fastening elements, each with a dowel pin clip, or a clamp at a first section of the fastening element, and a support element at a second section of the fastening element, so that the dowel pin clip or the clamp has to be inserted into, or clamped on the sensors housing at the first section, and the support element at the second section has to be fixed on the electrical conductor.

In an advantageous embodiment the support element of an arrangement of the at least two fastening elements are fixed on the electrical conductor commonly with a tightening strap or a fixating ring. This ensures an accurate and stabilized position of a voltage and/or current measurement device within the measured voltage and/or current signal source which has possitive effect to the voltage and/or current measurement device sensing accuracy. By the use of two fastening elements a good centered position of the sensor is given. But better are at least three fastening element.

In a further embodiment, the support element is provided with an eye-element, through which the tightening strap or fixation ring is guided, in order to fixe the position of the fastening element.

So in a very advantageous embodiment, the sensor geometry is a circular ring element, to be positioned round an electrical conductor.

In a further advantageous embodiment, the fixating ring or the tightening strap is removable, and or changeable in the position.

For fixation of this inventive fastening element there is no need to use an assembling tool and/or additional fastening material, they provide an option to apply a tightening strap, conducted through a specially designed segment, like an eye, of the mechanical fastening element and/or placed on the mechanical fastening element surface to obtain greater contact force if needed.

In a further embodiment the first section and the second section of the fastening element are connected together in a fixed angle position between 90° and 180°. Mostly advantageous is an angle defined by 90°.

An alternative embodiment is given by that the first section and the second section of the fastening element are connected in that way, that the angle position between the first and the second section is variable/adjustable between 90° and 180°.

This embodiment has its advantage in the in applications to electrical conductors with small diameters. As well, by this embodiment, the fastening element can be applied on several different conductor diameters.

A last advantageous embodiment describes, that the first section is pivotable relative to the second section in that way, that the pivotation plane is rectangular to the long axis of the conductor. This gives a simple but effective possibility to adapt the fastening elements to lower conductor diameter.

A last advantageous embodiment comprises the feature, that the contact side of the second section of the fastening element to the conductor surface is provided with a rough or structured surface or with such a surface coverage.

By this, a very good contact an sure positioning is given.

The invention is dealing with an improvement of a current and/or voltage sensing means or device positioning system and with increasing measurement device sensing accuracy as a result of the stable and fixed measurement device placement within a complete electrical system. It claims implementation of the unique fastening elements designed to ensure fast and easy instalation and stabilization of the current and/or voltage sensing device in a proper position with no assembling tool usage and, thus, to reduce amplitude error and phase displacement, as well as to reduce manufacturing time and production costs.

The inventions is shown in
Figure 1: side, front and detailed view of the fastening element with rectangular position of first to second section,
Figure 2: side, front and detailed view of the fastening element with angular position between 90 and 180°of first to second section,
Figure 3: side, front and detailed view of the fastening element with a pivotable first section

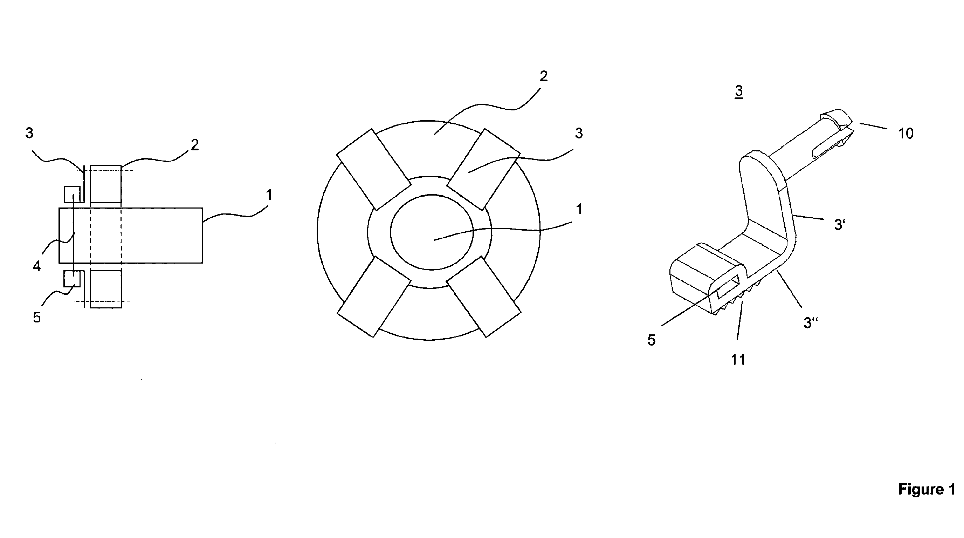

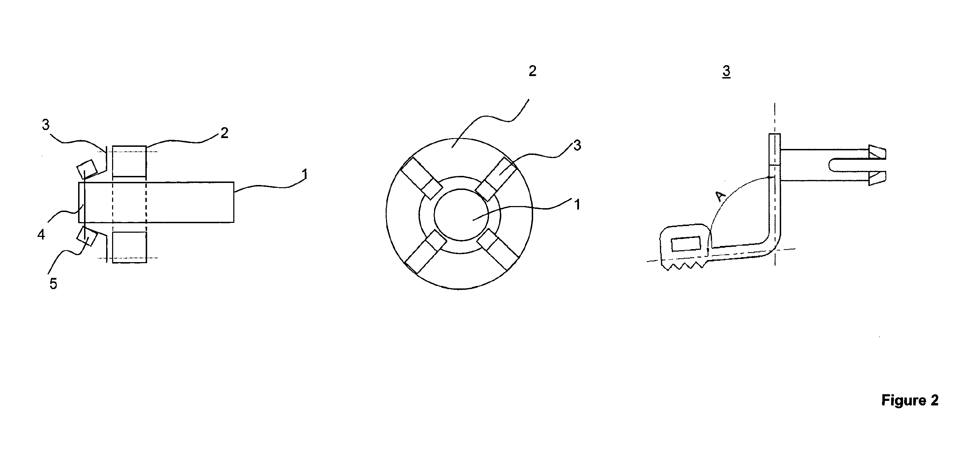

According to all embodiments this invention describes the application of the special construction fastening elements 3 ensuring the simple sensing device 2 fixation in the most appropriate position on the primary conductor 1 and, therefore a stable current and/or voltage signals measurement with high accuracy, like shown in figure 1. In case the greater contact force value between the fastening elements 3 and neither directly the primary conductor 1 or the electrical device containing the primary conductor 1 is needed the fastening element 3 design, which allows a possibility of using a tightening strap 4 conducted through a hole or eye-element 5 and/or placed on the fastening element 3 surface, like shown in figure 1 and figure 2.

In figure 1, the first section 3' is provided with a dowel pin 10, which has to be inserted into a hole in the housing of the sensor 2. The first section 3' is oriented in an angle of 90° to the second section 3". The second section 3" has to be brought into close contact to the surface of the conductor 1. For a good positioning, the contact side of the second section is provided with a structured surface area 11 or a such structured coverage.

Figure 2 shows the special design of the fastening element 3 that could be an option for the applications, where the primary conductor diameter is significantly smaller in comparison to the measurement of device 2 inners diameter. The proper contact force value between the fastening elements 3 and neither directly the primary conductor 1 or the electrical device containing the primary conductor 1 is ensured by introduction of the angle A, that has to be in the range 90° to 180°. This angle is defined between the first section and the second section of the fastening element.

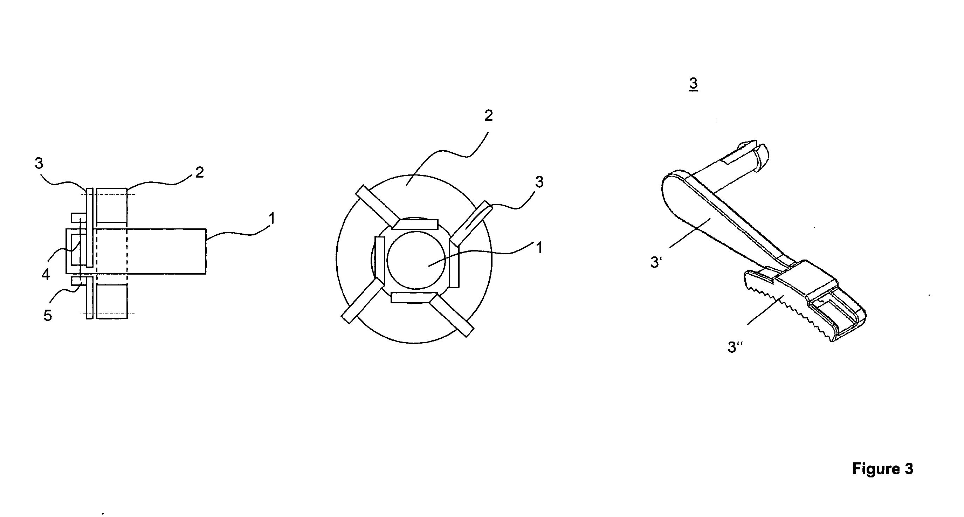

Figure 3 displays the concept of a pivotable first section 3' of the fastening element 3. So the first section 3' is pivotable to the second section, in a pivotation plane, which is rectangular to the long axis of conductor 2. Such a solution allows usage of the same sensing device 2, employing those rotating fastening elements 3, in the applications with different primary conductor 1 diameters and/or in the applications with different electrical device containing the primary conductor 3 sizes.

Material of the fastening components must be selected in such way to ensure the requested mechanical stability of the current and/or voltage measurement device, sufficient contact force between the fastening component surface and a surface of a device to which the current and/or voltage sensing device containing the fastening components is to be connected and easy mounting process and removal process of the current and/or voltage measurement device.

The advantages of the proposed solution are the reduction of the fastening material needed and the elimination of the special assembling tool necessity which enables both shortening of the manufacturing time and production cost cutting.

The next advantages are very easy and fast sensing device 2 mounting and removal and, as well, simple maintenance.

Additional significant advantage of the special fastening elements 3 application, as described above, is improved sensing accuracy of the measurement device 2 ensured by the stable and fixed sensing device 2 position within the measured current and/or voltage signal source (i.e. primary conductor 1).

The fastening of the sensor needs no special tools, and the positioning of the sensor could be realized with high reproductive accuracy.

### Position numbers

- 1: electrical conductor
- 2: sensor / sensor housing
- 3: fastening element

- 3': first section of the fastening element
- 3": second section of the fastening element

- 4: tightening strip
- 5: eye-element

- 10: dowel pin or clamp
- 11: strutured surface area, or structured coverage

## Claims

1. Fastening means or device for fastening a voltage and/or current sensor on a electrical conductor,
**characterized in**
**that** the fastening device comprise of a number of at least two fastening elements (3), each with a dowel pin clip, or a clamp at a first section (3') of the fastening element, and a support element at a second section (3") of the fastening element, so that the dowel pin clip (10) or the clamp has to be inserted into, or clamped on the housing of the sensor (2) at the first section (3'), and the support element at the second section (3") has to be fixed on the electrical conductor (1).

2. Fastening means according to claim 1,
**characterized in**
**that** the support element of an arrangement of the at least two fastening elements are fixed on the electrical conductor commonly with a tightening strap (4) or a fixating ring.

3. Fastening means according to claim 1 or 2,
**characterized in**
**that** the support element is provided with an eye-element (5), through which the tightening strap (4) or fixation ring is guided, in order to fixe the position of the fastening element.

4. Fastening means according to claim 1 or 2, or 3,
**characterized in**
**that** the sensor geometrie is a circular ring element, to be positioned round an electrical conductor.

5. Fastening means according to one of the aforesaid claims,
**characterized in**
**that** the fixating ring or the tightening strap is removable, and or changeable in the position.

6. Fastening means according to one of the aforesaid claims 1 to 5,
**characterized in**
**that** the first section and the second section of the fastening element are connected together in a fixed angle position between 90° and 180°.

7. Fastening means according to one of the aforesaid claims 1 to 5,
**characterized in**
**that** the first section (3') and the second section (3") of the fastening element are connected in that way, that the angle position between the first and the second section is variable between 90° and 180°.

8. Fastening means according to one of the aforesaid claims 1 to 5,
**characterized in**
**that** the first section (3') is pivotable relative to the second section (3") in that way, that the pivotation plane is rectangular to the long axis of the conductor.

9. Fastening means according to one of the aforesaid claims,
**characterized in**
**that** the contact side of the second section (3") of the fastening element to the conductor surface is provided with a rough or structured surface (11) or with such a surface coverage.
